# FASCICULE DE BREVET EUROPEEN

(11) **EP 3 264 109 B1**
(45) Date de publication et mention de la délivrance du brevet: **05.08.2020**
(21) Numéro de dépôt: 17178788.0
(22) Date de dépôt: 29.06.2017
(51) Int. Cl.: G01R 15/04, H01C 1/16, H01C 13/02, H02M 1/42, H01G 4/38, H01G 4/40

(54) **DISPOSITIF D'ISOLATION ELECTRIQUE**
VORRICHTUNG ZUR ELEKTRISCHEN ISOLIERUNG
ELECTRICAL INSULATION DEVICE

(30) Priorité: 01.07.2016 FR 1656290
(43) Date de publication de la demande: 03.01.2018
(73) Titulaire: Schneider Electric Industries SAS, 92500 Rueil-Malmaison (FR)
(72) Inventeur: MOLLIER, Christophe, 38050 GRENOBLE Cedex 9 (FR); CAOUS, Philippe, 38050 GRENOBLE Cedex 9 (FR); QUINTANA DELGADO, Sebastian, 38050 GRENOBLE Cedex 9 (FR)
(74) Mandataire: Brevalex

(56) Documents cités:
- US-A1- 2013 088 092
- US-A1- 2013 169 263

## Description

### DOMAINE TECHNIQUE

L'invention concerne un dispositif d'isolation électrique pour la mesure de tension de ligne à courant continu ou alternatif.

Plus particulièrement, la présente invention concerne un dispositif pourvu de diviseurs de tension destinés à protéger des surtensions lors des opérations de maintenance ou de surveillance d'une ligne basse tension. Par basse tension, nous entendons une ligne présentant une tension inférieure à 1200V alternatif et 1500V continu, par exemple 230V alternatif.

### ÉTAT DE LA TECHNIQUE ANTÉRIEURE

Les réseaux de production et de distribution électrique haute tension (HT) ont atteint une robustesse telle que les incidents électriques sont essentiellement observés au niveau des réseaux moyenne tension (MT) et basse tension (BT).

Cette évolution conduit donc à surveiller les tensions, avec des capteurs de tension, provenant de lignes MT et BT. Les contraintes normatives définies dans les normes IEC60664-1, IEC60255-27, IEC60255-5 imposent des isolements électriques à respecter pour assurer la sécurité des personnes, par exemple, lors de la manipulation des capteurs de tension, ou encore lors des opérations de maintenance ou de surveillance des réseaux BT. Ainsi, les normes susmentionnées et ou les usagers imposent de protéger, par exemple, les opérateurs d'éventuelles surtensions de l'ordre de 10 kV à 50 Hz pendant 10 minutes, et de l'ordre de 20 kV à 50 Hz pour une impulsion.

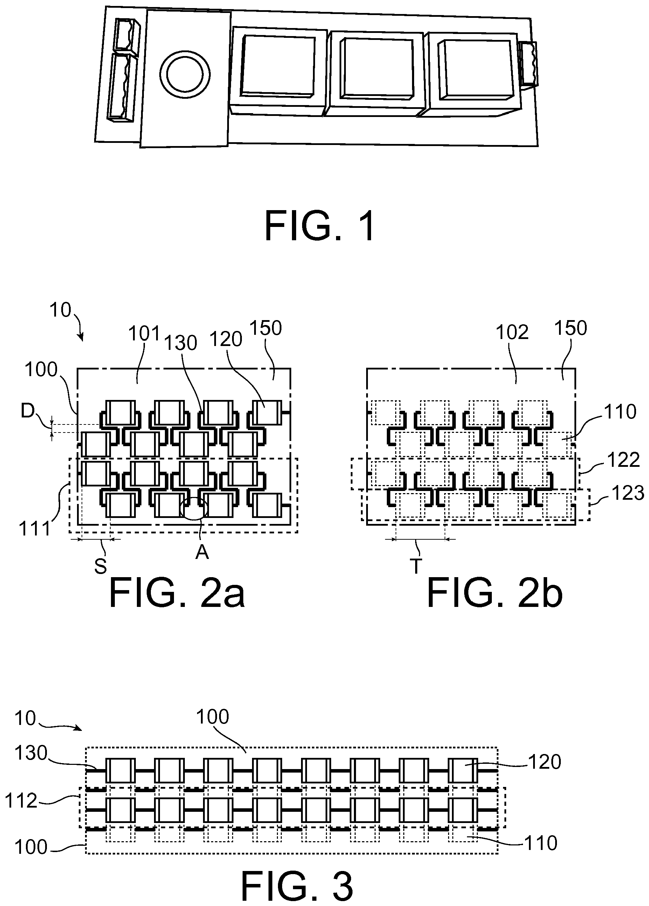

C'est pourquoi, pour assurer l'isolation électrique et la transformation des mesures des tensions triphasées BT, il a été proposé d'utiliser un transformateur de potentiel (tel que représenté à la figure 1).

Cependant, cette solution n'est pas satisfaisante.

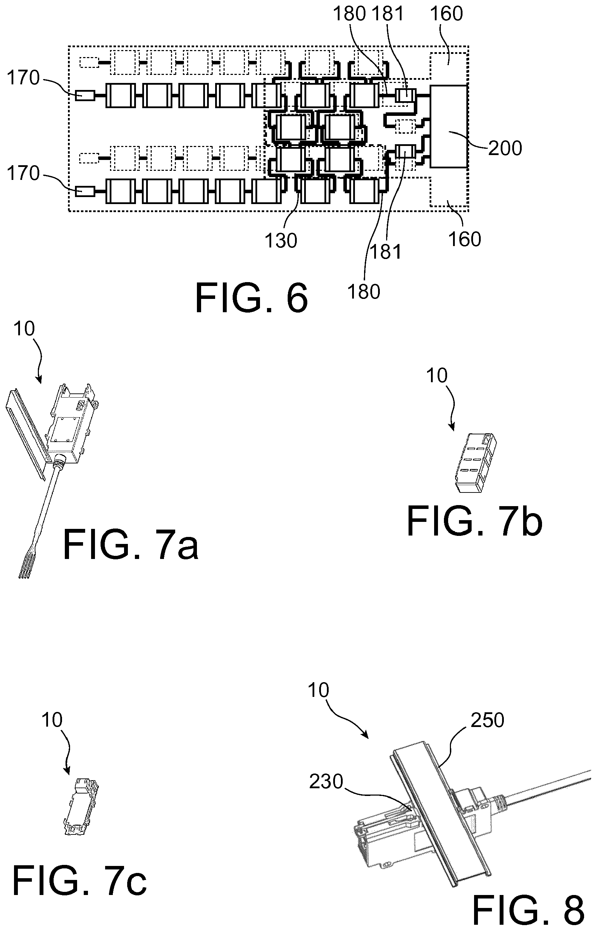

En effet, les transformateurs de potentiel (TP) sont lourds, et présentent un encombrement considérable, limitant ainsi leur intégration dans un système modulaire comprenant, par exemple, des modules agencés sur des rails DIN tel que représenté à la figure 8.

Par ailleurs, la tension mesurée aux bornes de sorties d'un TP ne varie pas linéairement avec la tension imposée en entrée dudit TP (cette dernière dépend, par exemple, de la fréquence de la tension mesurée, de la plage de tension dans laquelle se situe la tension...). Ainsi, la mise à l'échelle de la tension imposée en entrée du TP, et par ledit TP n'est pas linéaire. Par mise à l'échelle, nous entendons la transformation d'une tension en une autre tension (plus faible par exemple). Un système linéaire exécute une mise à l'échelle homothétique, autrement dit, la tension en entrée est multipliée par un facteur de proportionnalité constant, et donc indépendant de la tension en entrée. Cette non linéarité d'un TP nuit à la qualité et à la fiabilité des mesures de tension.

Alternativement, l'isolement peut également être assuré par des opto-coupleurs. Ces dispositifs nécessitent cependant une alimentation électrique et donc une connectique adaptée. Ils ne sont donc pas satisfaisants.

Le document US 2013/0088092 décrit un disposition d'isolation.

Un but de l'invention est donc de proposer un dispositif d'isolation présentant un encombrement plus faible que les isolateurs connus de l'état de la technique.

Un autre but de l'invention est de proposer un dispositif d'isolation adapté pour mettre à l'échelle une moyenne tension ne posant pas de problème de non linéarité.

Un autre but de l'invention est également de proposer un dispositif d'isolation respectant la forme d'onde de la tension électrique mesurée.

### EXPOSÉ DE L'INVENTION

Les buts de l'invention sont atteints par un dispositif d'isolation électrique comprenant :
- un support d'épaisseur E comprenant deux faces en regard, dites, respectivement, face avant et face arrière, les deux faces présentant une longueur L, une largeur l,
- sur chaque face du support est disposé une pluralité de diviseurs de tension s'étendant sur la longueur L de ladite face, chaque diviseur de tension comprenant des composants électriques connectées en série et agencées successivement selon un premier étage et un second étage, chaque premier étage comprenant une rangée de composants électriques pairs et une rangée de composants électriques impairs, les deux rangées étant parallèles selon la longueur L, et essentiellement adjacentes selon la largeur l, et le second étage correspondant à un agencement en ligne des composants électriques.

Selon un mode de mise en œuvre, pour chacune des rangées de composants électriques pairs et des rangées de composants électriques impairs, l'espacement selon la longueur L entre deux composants électriques d'une même rangée est inférieur à l'espacement nécessaire à l'insertion d'un composant électrique.

Selon un mode de mise en œuvre, l'espacement, selon la largeur l, des rangées de composants électriques pairs et des rangées de composants électriques impairs disposés sur une même face est régulier, cet espacement étant avantageusement inférieur à l'espacement nécessaire à l'insertion d'un composant électrique.

Selon un mode de mise en œuvre, dans chacune des rangées de composants électriques pairs et impairs, l'agencement desdits composants électriques est régulier selon un pas T dans la direction de la longueur L.

Selon un mode de mise en œuvre, les rangées paires des deux faces du support sont en phase entre elles, et les rangées impaires des deux faces du support sont également en phase entre elles.

Selon un mode de mise en œuvre, les rangées paires présentent un décalage selon la longueur L par rapport aux rangées impaires, le décalage étant avantageusement d'une demi-période T.

Selon un mode de mise en œuvre, le support comprend au moins une couche de blindage intercalée entre deux couches d'isolant électrique, et disposée essentiellement parallèlement aux deux faces du support, la couche de blindage étant adaptée pour réduire les diaphonies entre des composants électriques en regard les uns des autres au travers de l'épaisseur E du support.

Selon un mode de mise en œuvre, la couche de blindage comprend un métal, avantageusement, le métal comprend au moins un des éléments choisi parmi : cuivre.

Selon un mode de mise en œuvre, les deux couches d'isolant électrique comprennent un matériau diélectrique, avantageusement le matériau diélectrique comprend au moins un des éléments choisi parmi : époxy, FR4, bakélite.

Le FR4 est un type d'époxy renforcé de fibres de verre.

Selon un mode de mise en œuvre, les seconds étages sont agencés parallèlement les uns aux autres selon la longueur L, les seconds étages de la face avant étant décalés selon la largeur l par rapport aux seconds étages de la face arrière de sorte qu'aucun composant électrique des seconds étages d'une face ne soit en regard, même partiellement, d'un autre composant électrique disposé sur l'autre face.

Selon un mode de mise en œuvre, la couche de blindage ne s'étend que sur une première surface, la première surface étant la surface en regard de la surface occupée par les premiers étages.

Selon un mode de mise en œuvre, deux premiers étages, disposés chacun sur une face différente du support ne peuvent avoir qu'une seule rangée de composants électriques en regard l'une de l'autre au travers de l'épaisseur E du support, de sorte qu'au moins une rangée de composants sur une des deux faces n'est en regard d'aucune rangée disposée sur l'autre face.

Selon un mode de mise en œuvre, la couche de blindage ne s'étend que sur une seconde surface, la seconde surface étant limitée à la projection selon la direction E de la surface occupée par les rangées de la face avant ayant chacune une rangée de la face arrière en regard.

Selon un mode de mise en œuvre, les seconds étages des diviseurs de tension comprennent une extrémité libre destinée à être connectée à une source de basse tension.

Selon un mode de mise en œuvre, les premiers étages des diviseurs de tension comprennent chacun une extrémité libre destinée à être connectée à un dispositif de mesure de tension.

Selon un mode de mise en œuvre, un connecteur Ethernet du type RJ45 est disposé sur le support, de manière à assurer la connexion entre les extrémités libres des premiers étages et le dispositif de mesure de tension.

Selon un mode de mise en œuvre, les composants électriques des diviseurs de tension forment avec le support un circuit imprimé.

Selon un mode de mise en œuvre, tous les composants électriques de tous les diviseurs de tension sont identiques, avantageusement les composants électriques sont des résistance électriques.

Selon un mode de mise en œuvre, l'épaisseur E du support est inférieure à 1,6 mm.

Selon un mode de mise en œuvre, le support comprend en outre un moulage et un surmoulage destinés à assurer, respectivement, une isolation électrique et une tenue mécanique du dispositif.

Selon un mode de mise en œuvre, le dispositif est pourvu de moyens de fixation sur un rail, par exemple un rail DIN.

### BRÈVE DESCRIPTION DES DESSINS

D'autres caractéristiques et avantages apparaîtront dans la description qui va suivre des modes de mise en œuvre d'un dispositif d'isolation électrique selon l'invention, donnés à titre d'exemples non limitatifs, en référence aux dessins annexés dans lesquels :
- la figure 1 est une représentation d'un transformateur de potentiel connu de l'art antérieur,
- les figures 2a et 2b sont des représentations schématiques de la disposition des résistances électriques du premier étage des diviseurs de tension selon l'invention, la figure 2b représentant en transparence lesdits premiers étages disposés sur la face arrière du support,
- la figure 3 est une représentation schématique de la disposition des résistances électriques, selon l'invention, des seconds étages de chaque diviseur de tension sur chacune des faces du support, les seconds étages disposés sur la face arrière sont observés par transparence,
- la figure 4 est une représentation schématique d'une couche de blindage comprenant 3 couches superposées d'isolant,
- les figures 5a et 5b sont des représentations schématiques du dispositif d'isolation électrique, selon l'invention, en vue de dessus (figure 5a) et par transparence au travers de la face avant (figure 5b),
- la figure 6 est une représentation schématique, selon l'invention, du dispositif d'isolation électrique (les résistances électriques de la face arrière étant vues par transparence au travers de la face avant),
- les figures 7a, b, c sont une représentation schématique, selon l'invention, du dispositif d'isolation électrique avant le moulage (figure 7a), du moulage destiné à venir autour du dispositif d'isolation (figure 7b) et du surmoulage destiné à venir autour du moulage (figure 7c),
- la figure 8 est une représentation schématique, selon l'invention, du dispositif d'isolation électrique monté sur un rail DIN,
- la figure 9a est une représentation schématique du volet de protection pris isolément,
- la figure 9b est une représentation schématique du volet de protection inséré dans le dispositif d'isolation électrique selon l'invention.

### EXPOSÉ DÉTAILLÉ DE MODES DE RÉALISATION PARTICULIERS

Pour les différents modes de mise en œuvre, les mêmes références seront utilisées pour des éléments identiques ou assurant la même fonction, par souci de simplification de la description. Sur les figures 2 à 8, on peut voir des exemples de réalisation d'un dispositif d'isolation électrique 10 selon la présente invention.

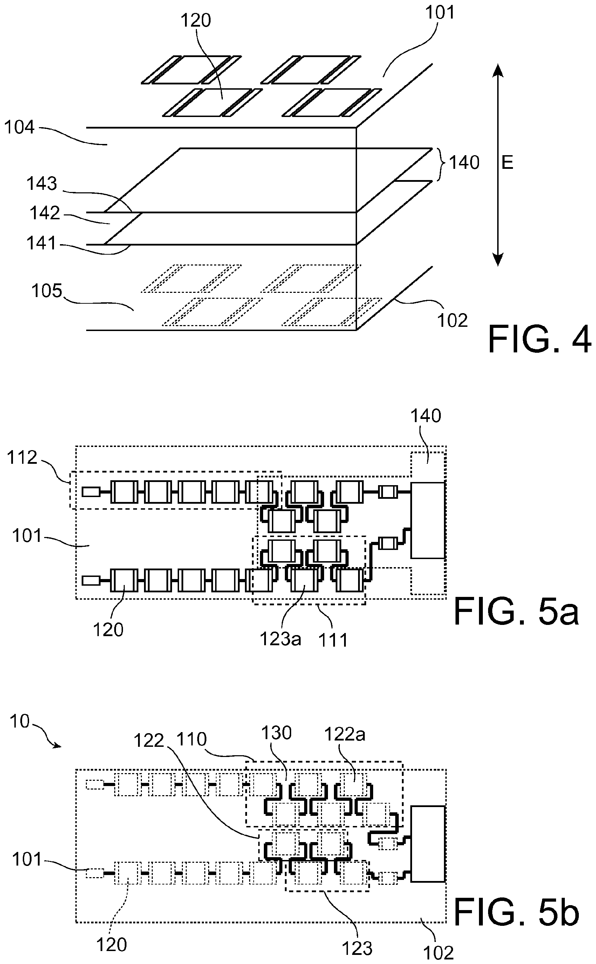

Le dispositif d'isolation électrique 10 comprend un support 100 d'épaisseur E (figure 4).

Le support 100 comprend deux faces 101 et 102 essentiellement parallèles, dites par convention, face avant 101 et face arrière 102. Les faces avant 101 et arrière 102 sont reliées par une surface de contour. La face avant 101 et la face arrière 102 peuvent être de forme rectangulaire de longueur L et de largeur l.

Nous considérerons tout au long de l'exposé que la longueur L est supérieure à la largeur l. Le support 100 peut être un support 100 pour circuit imprimé (« PCB » ou « Printed Circuit Board » selon la terminologie Anglo-Saxonne).

Nous confondrons également tout au long de l'énoncé la longueur du support 100 et la longueur des faces avant 101 et arrière 102.

Le support a une épaisseur E. Par épaisseur E du support, nous entendons la distance entre la face avant 101 et la face arrière 102 du support selon une direction perpendiculaire à une des faces 101 et 102.

Sauf précision contraire, nous confondrons tout au long de l'énoncé, la longueur L et la direction selon la longueur L.

Sauf précision contraire, nous confondrons tout au long de l'énoncé, la largeur l et la direction selon la largeur l.

Sauf précision contraire, nous confondrons tout au long de l'énoncé, l'épaisseur E et la direction selon l'épaisseur E.

Sur chacune des faces (la face avant 101 et la face arrière 102) du support 100, est disposée une pluralité de diviseurs de tension 110. Les diviseurs de tension 110 selon l'invention comprennent des composants électriques 120 connectés en série. Par connectés en série, nous entendons électriquement connectés en série, aussi tout au long de l'exposé, par souci de simplification, nous omettrons le terme « électriquement ».

Il est évident sans qu'il soit nécessaire de le préciser que les diviseurs de tension 110 sont électriquement isolés les uns des autres.

Les composants électriques 120 peuvent comprendre des résistances électriques ou des capacitances.

Les modes de réalisation de l'invention qui suivent vont être décrits dans le contexte de composant électriques constitués de résistances électriques, étant entendu que lesdits modes de réalisation peuvent très bien être mis en œuvre avec des capacitances.

La connexion électrique entre les résistances électriques 120 est assurée par des pistes 130 métalliques.

Les résistances électriques 120 sont avantageusement déposées sur la face avant 101 et la face arrière 102, et brasées sur les pistes métalliques 130. Nous ne détaillerons pas ces étapes de fabrication qui sont connues de l'homme du métier.

Chaque diviseur de tension 110 n'est formé que sur une des deux faces du support 100. Autrement dit, il n'y a aucune connexion électrique entre deux résistances électriques 120 disposées de part et d'autre du support 100. En outre, chaque diviseur de tension 110 s'étend selon la longueur L de la surface sur laquelle il est disposé. Par s'étendre selon la longueur L de la surface, nous entendons que le diviseur de tension 110 est essentiellement parallèle à la direction définie par ladite longueur L. Ainsi, dès lors que chaque diviseur de tension 110 s'étend selon la longueur L de la face sur laquelle il est disposé, l'homme du métier comprend que les diviseurs de tension 110 sont parallèles entre eux.

Les résistances électriques 120 de chaque diviseur de tension 110 sont agencées successivement selon un premier étage 111 (encadrés en traits discontinus de la figure 2a) et un second étage 112 (encadré en traits discontinus de la figure 3).

Chaque premier étage 111 comprend une rangée de résistances électriques paires 122 et une rangée de résistances électriques impaires 123 (encadré en traits discontinus de la figure 2b). Les deux rangées de résistances électriques paires 122 et impaires 123 sont parallèles entre elles selon la longueur L de la face 101/102 du support 100 sur laquelle elles sont disposées. Autrement dit toutes les rangées de résistances paires 122 et impaires 123 de tous les diviseurs de tension 110 sont parallèles entre elles selon la direction définie par la longueur L des deux faces avant 101 et arrière 102. Par résistance électrique paire 122 ou résistance électrique impaire 123, nous entendons la parité de sa position dans la connexion en série. La connexion en série des résistances électriques 120 du premier étage 111 peut être agencée de sorte qu'une résistance électrique 120 sur deux soit une résistance électrique 120 de la rangée paire 122 dudit premier étage 111, et l'autre résistance électrique 120 soit une résistance électrique 120 de la rangée impaires 123 du même premier étage. Autrement dit, une résistance électrique impaire 123 ne peut être connectée qu'à des résistances électriques paires 122 en entrée et en sortie. De la même manière, une résistance électrique paire 122 ne peut être connectée qu'à des résistances électriques impaires 123 en entrée et en sortie. Il est entendu, dans cette configuration, que les deux résistances électriques 120, disposées en extrémité du premier étage 111, ne sont connectées qu'à une seule résistance électrique 120 du même premier étage.

Les deux rangées 122 et 123 de résistances électriques du premier étage 111 d'un diviseur de tension 110 sont essentiellement adjacentes selon la largeur l. Par essentiellement adjacente, nous entendons que la rangée de résistances électriques impaires 123 peut présenter un léger décalage (décalage S illustré à la figure 2), en terme de positionnement, selon la longueur L, par rapport à la rangée de résistances électriques paires 122. Le léger décalage peut être inférieur à la longueur d'une résistance électrique.

En outre, selon un mode de réalisation avantageux, une résistance électrique d'une rangée d'un premier étage est connectée en série avec les deux résistances électriques de l'autre rangée dudit premier étage qui lui sont les plus proches (à l'exception des deux résistances électriques 120 en extrémité du premier étage). Ainsi, la longueur des pistes 130 peut être la plus courte possible. Par ailleurs, selon cette configuration, la différence de potentiel des deux pistes 130 connectée, chacune, à l'entrée et à la sortie d'une même résistance électrique 120 est suffisamment faible pour éviter un arc électrique dans la région du support où les deux pistes sont le plus proche l'une de l'autre (point A de la figure 2a).

Le second étage 112 de chaque diviseur de tension 110 comprend des résistances électriques 120 agencées en ligne.

Etant donné que chaque diviseur de tension 110 s'étend selon la longueur L des deux faces avant 101 et arrière 102 du support 100, il apparait clairement à l'homme du métier que tous les seconds étages 112 sont également parallèles entre eux.

Ainsi, la disposition des diviseurs de tension 110 sur les deux faces 101/102 du support 100 permet de réduire la largeur du support 100, et par conséquent de réduire l'encombrement du dispositif d'isolation électrique 10 selon l'invention.

Par ailleurs, l'agencement d'une partie des résistances électriques 120 pour chaque diviseur de tension 110 selon un premier étage 111 permet également de réduire la longueur de chaque diviseur de tension 110 par rapport à un diviseur de tension 110 ne comprenant que des résistances électriques 120 connectées en série et agencées linéairement.

En outre, l'isolation par des diviseurs de tension 110 comprenant des résistances électriques 120 connectées en série ne présentent pas de non linéarités telles que celles observées dans les transformateurs de potentiel. Ainsi, le diviseur de tension 110 peut mettre à l'échelle la tension, prélevée sur une phase d'un réseau triphasé par exemple, de manière homothétique (i.e. : aucune distorsion de la forme d'onde de la tension n'est induite par le diviseur de tension).

Enfin, les diviseurs de tension 110 selon l'invention ne nécessitent pas d'alimentation pour fonctionner.

Avantageusement, l'espacement selon la longueur L entre deux résistances électriques 120 d'une même rangée de résistances électriques paires 122 ou impaires 123 est inférieur à l'espacement nécessaire à l'insertion d'une résistance électrique. Ainsi, l'agencement du premier étage 111 permet d'augmenter la densité « linéaire » de résistances électriques 120 selon la longueur L des faces du support 100. Par densité « linéaire » de résistances électriques 120 selon la longueur L, nous entendons le nombre de résistances électriques 120 par unité de longueur du diviseur de tension 110. A titre d'exemple, les résistances électriques 120 des diviseurs de tension 110, au niveau du premier étage 111, peuvent comprendre de l'oxyde de ruthénium, être de forme parallélépipédique de 6.8mm de long, de 3.4mm de large et de 0.7mm de hauteur.

L'espacement, selon la longueur L, entre résistances électriques 120 peut être de 2 mm.

De manière avantageuse, pour chacune des rangées de résistances électriques paires 122 et impaires 123, l'agencement desdites résistances électriques 120 peut être régulier selon la longueur L. Par régulier, nous entendons le même espacement entre deux résistances électriques 120 consécutives d'une même rangée, quelles que soient les résistances électriques 120 de ladite rangée considérées. Nous disons que l'agencement des résistances électriques 120 d'une rangée selon la longueur L est périodique, et de pas T. L'espacement entre résistances électriques 120 peut être le même pour toutes les rangées de résistances électriques paires 122 et impaires 123.

De manière avantageuse, tous les premiers étages 111 du dispositif d'isolation électrique 10 peuvent être identiques. Ainsi, tous les seconds étages 112 d'une même face peuvent être adjacents deux-à-deux, de sorte que la longueur L du support 100 peut être optimisée (i.e. : réduite).

Toujours de manière avantageuse, tous les seconds étages 112 du dispositif d'isolation électrique 10 peuvent être identiques.

Selon un mode de réalisation avantageux, les rangées de résistances électriques paires 122 et impaires 123 d'une même face peuvent être espacées, selon la largeur l, deux à deux, d'un espacement inférieur à l'espacement nécessaire à l'insertion d'une résistance électrique. Avantageusement, cet espacement peut être régulier. Par régulier, nous entendons le même espacement quelles que soient les deux rangées adjacentes considérées d'une même face 101/102.

Les rangées de résistances électriques paires 122 des deux faces 101/102 du support 100 peuvent être en phase entre elles.

Les rangées de résistances électriques impaires 123 des deux faces du support 100 peuvent être en phase entre elles.

Par rangées de résistances électrique paires 122 (impaires 123) en phase, nous entendons que chaque rangée de résistances paires 122 (impaires 123) peut être obtenue par une opération de translation d'une autre rangée de résistances électriques paires 122 (impaires 123) selon la largeur l et/ou selon l'épaisseur E (autrement dit selon une direction perpendiculaire à la longueur L).

De manière avantageuse, les rangées de résistances électriques paires 122 présentent un décalage S (représenté sur la figure 2a) selon la longueur L par rapport aux rangées de résistances électriques impaires 123.

Le décalage peut avantageusement être d'un demi pas T/2. Ainsi, la longueur des pistes 130, reliant électriquement les résistances électriques 120 entre elles, peut être relativement courte.

Selon l'agencement proposé, des résistances électriques 120 d'une face peuvent être, au moins partiellement, en regard de résistances électriques 120 de l'autre face, et ainsi générer des diaphonies (« Cross talk » selon la terminologie Anglo-Saxonne).

Il est possible de prévenir ce phénomène en disposant des moyens adaptés pour réduire lesdites diaphonies.

Par résistances électriques 120, au moins partiellement, en regard, nous entendons que la projection perpendiculaire d'une résistance électrique d'une face sur l'autre face, selon l'épaisseur E, est au moins partiellement en recouvrement d'une résistance électrique disposée sur ladite autre face.

Parmi les moyens adaptés pour réduire les diaphonies, il peut être envisagé de considérer un support 100 d'épaisseur suffisante. Par exemple, un support 100 comprenant un matériau diélectrique, et d'épaisseur d'au moins 3 mm, permettra de réduire presqu'en totalité les diaphonies entre deux résistances en regard l'une de l'autre.

Afin de réduire les diaphonies, il est également possible d'introduire une couche de blindage 140 (figure 4) dans le volume du support 100. Autrement dit, le support 100 peut comprendre une couche de blindage 140 intercalée entre deux couches d'isolant électrique 104/105. Par couche de blindage 140, nous entendons une couche susceptible d'atténuer, voire empêcher, les échanges ou communications électromagnétiques entre deux résistances électriques 120 en regard l'une de l'autre. Autrement dit, la couche de blindage 140 écrante les diaphonies. Les deux couches d'isolant électrique 104/105 peuvent comprendre au moins un des matériaux choisi parmi : époxy, FR4, bakélite.

La couche de blindage 140 peut être disposée essentiellement parallèlement aux deux couches d'isolant.

La couche de blindage 140 peut s'étendre sur une étendue équivalente à celle des faces avant 101 et arrière 102.

La couche de blindage 140 peut comprendre un empilement de plusieurs couches. Par exemple, la couche de blindage 140 peut comprendre successivement une première couche métallique 141, une couche faite d'un matériau isolant 142, et une seconde couche métallique 143.

La première 141 et la seconde 143 couches métalliques peuvent comprendre du cuivre.

La première 141 et la seconde 143 couches métalliques peuvent présenter une épaisseur de 17,5 µm, et la couche faite du matériau isolant 142 présenter une épaisseur de 200 µm.

Nous allons maintenant décrire un arrangement particulier des seconds étages 112 permettant de réduire l'épaisseur du support 100. En effet, l'épaisseur de la couche de blindage 140 est directement proportionnelle à son étendue. Ainsi, selon un mode de réalisation particulier de l'invention, il peut être requis de réduire l'étendue de la couche de blindage 140 afin de réduire également l'épaisseur E du support 100.

Ainsi, avantageusement, la couche de blindage 140 ne s'étend que sur une première surface 150, la première surface 150 étant la surface en regard de la surface occupée par les premiers étages 111 sur la face avant 101 et la face arrière 102.

La réduction de la surface occupée par la couche de blindage 140 permet de réduire l'épaisseur de cette dernière tout en conservant une efficacité équivalente en termes d'écrantage de diaphonies au niveau des premiers étages 111.

Par contre l'écrantage des diaphonies au niveau des seconds étages n'est plus efficace. Ainsi, il peut être intéressant de conférer auxdits seconds étages 112 une disposition particulière.

Avantageusement, les seconds étages 112 sont agencés parallèlement les uns aux autres selon la longueur L, les seconds étages 112 de la face avant 101 étant décalés selon la largeur l par rapport aux seconds étages 112 de la face arrière 102 de sorte qu'aucune résistance électrique des seconds étages 112 d'une face ne soit en regard, même partiellement, d'une autre résistance électrique disposée sur l'autre face. Ainsi, selon cet agencement des seconds étages 112, il n'y a pas de diaphonie entre les résistances électriques 120 comprises dans les seconds étages 112. Cet agencement justifie ainsi la limitation de l'étendue de la couche de blindage 140 à la première surface 150, et permet ainsi une réduction de l'épaisseur du support 100.

Avantageusement, deux premiers étages 111, disposés chacun sur une face différente du support 100 peuvent n'avoir qu'une seule rangée de résistances électriques 120 en regard l'une de l'autre au travers de l'épaisseur E du support 100, de sorte qu'au moins une rangée de résistances sur une des deux faces n'est en regard d'aucune rangée disposée sur l'autre face. Il peut ainsi être considéré de réduire encore l'étendue de la couche de blindage 140 à une surface au travers de laquelle des résistances électriques 120 des premiers étages 111 sont en regard. Ainsi, la couche de blindage 140 ne s'étend que sur une seconde surface 160, la seconde surface 160 étant limitée à la projection selon la direction E de la surface occupée par les rangées de la face avant 101 ayant chacune une rangée de la face arrière 102 en regard. Ainsi, dès lors qu'il n'y a que quatre rangées de résistance électrique sur une face, seules trois des quatre rangées de résistances électriques nécessitent un écrantage par la couche de blindage.

Pour les modes de réalisation présentés, les seconds étages 112 des diviseurs de tension 110 peuvent comprendre une extrémité libre 170 (figure 6) destinée à être connectée à une source de basse tension. Par exemple, le dispositif d'isolation électrique 10 peut comprendre quatre diviseurs de tension 110, et par conséquent quatre seconds étages 112, disposés de part et d'autre du support 100, lesdits quatre seconds étages 112 étant destinés à prélever les tensions d'une ligne triphasée (par exemple une ligne triphasée base tension comprenant 3 phases et un neutre).

Pour tous les modes de réalisations présentés, les premiers étages 111 des diviseurs de tension 110 peuvent comprendre une extrémité libre 180 (figure 6) destinée à être connectée à un dispositif de mesure de tension. Par exemple, le dispositif d'isolation électrique 10 peut comprendre quatre diviseurs de tension 110, et par conséquent quatre premiers étages 111, disposés de part et d'autre du support 100, lesdits quatre seconds étages 112 étant destinés à communiquer une tension à un dispositif de mesure de tension (un voltmètre par exemple, non représenté).

Nous allons maintenant décrire un exemple de réalisation d'un dispositif d'isolation électrique 10 selon l'invention en référence aux figures 5 et 6.

Dans l'exemple présenté, le dispositif d'isolation électrique 10 est destiné à assurer une isolation d'une ligne basse tension triphasée conformément à la norme IEC60664-1, IEC60255-27, IEC60255-5.

Le dispositif d'isolation électrique 10 comprend donc quatre diviseurs de tension 110 identiques disposés par paires sur chacune des faces d'un support 100.

Le support présente une longueur L de 76mm, une largeur l de 29mm, et une épaisseur E de 1.6 mm.

Chaque diviseur de tension 110 comprend des résistances électriques 120 électriquement connectées en série et agencées selon un premier étage 111 et un second étage 112, chaque étage comprenant quatre résistances électriques 120. Les diviseurs de tension 110 peuvent, chacun, comprendre une résistance, dite « résistance de pied » 181, connecté en série au niveau de l'extrémité 180 du premier étage 111.

Les résistances électriques 120 peuvent être en oxyde de ruthénium, et peuvent présenter une résistance électrique de 3.16^{∗}10⁶ ohm.

Les seconds étages 112 sont agencés parallèlement les uns aux autres selon la longueur L, les seconds étages 112 de la face avant 101 pouvant être décalés d'une distance 0.5mm (sur la figure 3) selon la largeur l par rapport aux seconds étages 112 de la face arrière 102 de sorte qu'aucune résistance électrique des seconds étages 112 d'une face ne soit en regard, même partiellement, d'une autre résistance électrique disposée sur l'autre face.

Les premiers étages 111 sont également agencés de sorte qu'une rangée de résistances électrique paires 122a sur une face et une rangée de résistances électriques impaires 123a sur l'autre face ne soient chacune en regard d'aucune rangée de résistances électrique. Cette configuration permet de limiter la surface de la couche de blindage 140 à la seconde surface 160 présentée à la figure 6. Aucun écrantage des diaphonies n'est nécessaire au niveau des rangées 122a et 123a.

La couche de blindage 140 comprend successivement une couche faite d'un matériau diélectrique, de 200 µm d'épaisseur, intercalée entre deux couches de cuivre de 17,5 µm d'épaisseur chacune. La couche de blindage 140 est quant à elle intercalée entre deux couches d'un matériau diélectrique de 650 µm d'épaisseur chacune. L'épaisseur du support 100 est ainsi d'environ 1,6 mm.

L'extrémité libre 180, ou, le cas échéant, la résistance de pied 181, des premiers étages 111 peut être connectée à un dispositif de mesure de tension par l'intermédiaire d'un connecteur 200 (un connecteur Ethernet RJ45 par exemple).

Le dispositif d'isolation électrique 10 (figure 7a) peut comprendre un moulage (figure 7b) et un surmoulage (figure 7c) destiné à assurer une meilleure isolation, une meilleure tenue mécanique, ainsi qu'une protection contre l'humidité.

Le matériau utilisé pour le moulage peut présenter une faible variation dimensionnelle en température et sous contrainte mécanique, ainsi qu'une bonne tenue diélectrique et une compatibilité chimique avec les composants électroniques, afin de ne pas dégrader les composants internes. Par exemple, le matériau utilisé pour le moulage peut comprendre une résine polyester thermoplastique fibrée, par exemple : RYNITE™ 415HP.

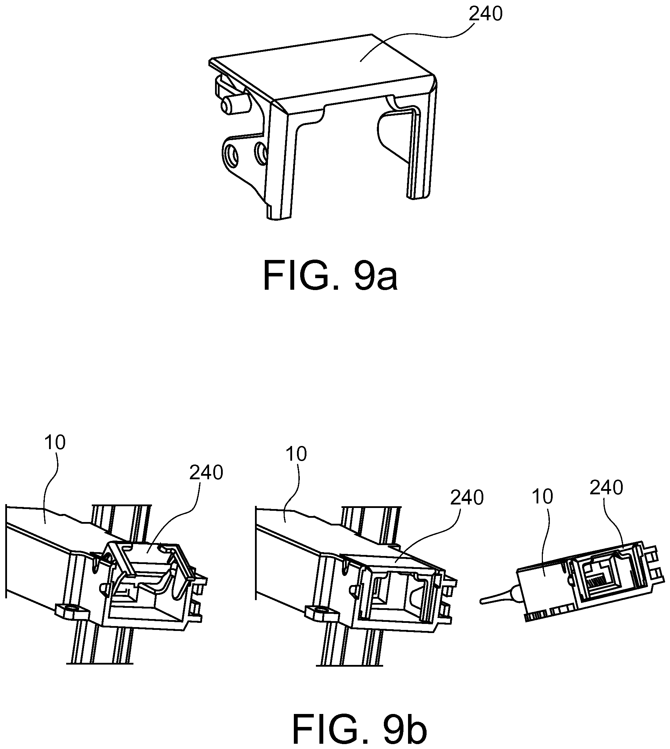

Le dispositif d'isolation électrique 10 peut également comprendre un volet de protection 240 au niveau du connecteur 200 de manière à garantir un indice de protection IP2x (figures 9a et 9b). Ledit volet de protection peut également comprendre deux ouvertures destinées à loger, chacune, un scellé dans une position indiquant qu'un câble de connexion est inséré ou retiré. Le scellé empêche également toute mauvaise manipulation involontaire.

Le dispositif peut également comprendre une borne de mise à la terre. La borne de mise à la terre permet d'adapter aisément, lors de l'installation, le dispositif d'isolation selon l'invention au type de régime de neutre moyenne tension ou basse tension. Par ailleurs, la borne de mise à la terre permet un renforcement de la tenue aux perturbations électromagnétiques.

Enfin, le dispositif d'isolation électrique 10 peut comprendre des moyens de fixation 230 sur un rail 250, par exemple sur un rail DIN (figure 8). Les moyens de fixation 230 peuvent, par exemple, comprendre un système à buttée monté sur ressort.

Alternativement, ou de manière complémentaire, les moyens de fixation peuvent comprendre des fixations Telequick™.

Les éléments et caractéristiques décrits dans ce dernier mode de réalisation sont transposables aux autres modes de réalisation décrits dans l'invention.

Le dispositif d'isolation électrique 10 selon l'invention peut se présenter sous forme d'un module et de taille réduite par rapport aux solutions connues de l'état de la technique. Il peut ainsi être fixé sur un tableau électrique regroupant d'autres éléments.

Le dispositif ne nécessite aucune alimentation pour fonctionner et présente des caractéristiques électriques linéaires.

Le tableau électrique peut regrouper un ensemble de modules (par exemple des modules MT et des modules BT) disposés sur des Rails (par exemple des rails DIN).

Le dispositif d'isolation 10 selon l'invention répond aux exigences de la norme IEC60664-1, IEC60255-27, IEC60255-5, et permet d'assurer la sécurité des opérateurs lors des opérations de maintenance et/ou de suivi des installations électriques (les installations domestiques par exemple).

Le dispositif d'isolation 10 selon l'invention comprend également des diviseurs de tension faits de composant passifs linéaires (les résistances électriques 120) qui assurent ainsi une mise à l'échelle de manière linéaire de la tension destinée à être mesurées. Les dispositifs d'isolation 10 répondent ainsi aux critères de qualité de mesure exigés.

## Revendications

1. Dispositif d'isolation électrique (10) comprenant :
- un support (100) d'épaisseur E comprenant deux faces en regard, dites, respectivement, face avant (101) et face arrière (102), les deux faces présentant une longueur L, une largeur l,
- sur chaque face du support (100) étant disposé une pluralité de diviseurs de tension (110) s'étendant sur la longueur L de ladite face, chaque diviseur de tension (110) comprenant des composants électriques (120) connectés en série et agencés successivement selon un premier étage (111) et un second étage (112), chaque premier étage (111) comprenant une rangée de composants électriques pairs (122) et une rangée de composants électriques impairs (123), les deux rangées étant parallèles selon la longueur L, et adjacentes selon la largeur l, et le second étage (112) correspondant à un agencement en ligne des composants électriques (120).

2. Dispositif selon la revendication 1, dans lequel pour chacune des rangées de composants électriques paires (122) et des rangées de composants électriques impaires (123), l'espacement selon la longueur L entre deux composants électriques (120) d'une même rangée est inférieur à l'espacement nécessaire à l'insertion d'un composant électrique.

3. Dispositif selon la revendication 1 ou 2, dans lequel l'espacement, selon la largeur l, des rangées de composants électriques pairs (122) et des rangées de composants électriques impairs (123) disposées sur une même face est régulier, cet espacement étant avantageusement inférieur à l'espacement nécessaire à l'insertion d'un composant électrique.

4. Dispositif selon l'une des revendications 1 à 3, dans lequel dans chacune des rangées de composants électriques pairs (122) et impairs (123), l'agencement desdits composants électriques est régulier selon un pas T dans la direction de la longueur L.

5. Dispositif selon la revendication 4, dans lequel les rangées de composants électriques pairs (122) des deux faces du support (100) sont en phase entre elles, et les rangées de composants électriques impairs (123) des deux faces du support (100) sont également en phase entre elles, avantageusement, les rangées de composants électriques pairs (122) présentent un décalage selon la longueur L par rapport aux rangées de composants électriques impairs (123), le décalage étant avantageusement d'un demi pas T/2.

6. Dispositif selon l'une des revendications 1 à 5, dans lequel le support (100) comprend une couche de blindage (140) intercalée entre deux couches d'isolant électrique (104/105), et disposée parallèlement aux deux faces du support (100), la couche de blindage (140) étant adaptée pour réduire les diaphonies entre des composants électriques (120) en regard les uns des autres au travers de l'épaisseur E du support (100).

7. Dispositif selon l'une des revendications 1 à 6, dans lequel les seconds étages (112) sont agencés parallèlement les uns aux autres selon la longueur L, les seconds étages (112) de la face avant étant décalés selon la largeur l par rapport aux seconds étages (112) de la face arrière (102) de sorte qu'aucun composant électrique des seconds étages (112) d'une face ne soit en regard, même partiellement, d'un autre composant électrique disposé sur l'autre face.

8. Dispositif selon la revendication 7, dans lequel la couche de blindage (140) ne s'étend que sur une première surface (150), la première surface (150) étant la surface en regard de la surface occupée par les premiers étages (111).

9. Dispositif selon la revendication 8, dans lequel deux premiers étages (111), disposés chacun sur une face différente du support (100) ne peuvent avoir qu'une seule rangée de composants électriques (120) en regard l'une de l'autre au travers de l'épaisseur E du support (100), de sorte qu'au moins une rangée de composants sur une des deux faces n'est en regard d'aucune rangée disposée sur l'autre face, avantageusement, la couche de blindage (140) ne s'étend que sur une seconde surface (160), la seconde surface (160) étant limitée à la projection selon la direction E de la surface occupée par les rangées de la face avant (101) ayant chacune une rangée de la face arrière (102) en regard.

10. Dispositif selon l'une des revendications 1 à 9, dans lequel les seconds étages (111) des diviseurs de tension (110) comprennent une extrémité libre destinée à être connectée à une source de basse tension.

11. Dispositif selon l'une des revendications 1 à 10, dans lequel les premiers étages (112) des diviseurs de tension (110) comprennent chacun une extrémité libre destinée à être connectée à un dispositif de mesure de tension, avantageusement, un connecteur Ethernet du type RJ45 est disposé sur le support (100), de manière à assurer la connexion entre les extrémités libres des premiers étages (112) et le dispositif de mesure de tension.

12. Dispositif selon l'une des revendications 1 à 11, dans lequel les composants électriques des diviseurs de tension (110) forment avec le support (100) un circuit imprimé.

13. Dispositif selon l'une des revendications 1 à 12, dans lequel tous les composants électriques (120) de tous les diviseurs de tension (110) sont identiques, avantageusement les composant électriques sont des résistances électriques.

14. Dispositif selon l'une des revendications 1 à 13, dans lequel le support (100) comprenant les diviseurs de tension (110) comprend en outre un moulage et un surmoulage destinés à assurer une isolation électrique et une tenue mécanique du dispositif.

15. Dispositif selon la revendication 14, dans lequel le dispositif est pourvu de moyens de fixation (230) sur un rail (250), par exemple un rail DIN.

## Patentansprüche

1. Vorrichtung zur elektrischen Isolierung (10), umfassend:
- einen Träger (100) der Dicke E, der zwei einander gegenüberliegende Seiten aufweist, die als Vorderseite (101) bzw. Rückseite (102) bezeichnet werden, wobei die beiden Seiten eine Länge L und eine Breite l aufweisen,
- wobei auf jeder Seite des Trägers (100) eine Vielzahl von Spannungsteilern (110) angeordnet ist, die sich über die Länge L dieser Fläche erstrecken, wobei jeder Spannungsteiler (110) elektrische Bauelemente (120) aufweist, die in Reihe geschaltet und aufeinanderfolgend in einer ersten Stufe (111) und einer zweiten Stufe (112) angeordnet sind, wobei jede erste Stufe (111) eine Reihe geradzahliger elektrischer Bauelemente (122) und eine Reihe ungeradzahliger elektrischer Bauelemente (123) aufweist, wobei die beiden Reihen entlang der Länge L parallel und entlang der Breite l benachbart sind und die zweite Stufe (112) einer Linienanordnung der elektrischen Bauelemente (120) entspricht.

2. Vorrichtung nach Anspruch 1, wobei für jede der Reihen geradzahliger elektrischer Bauelemente (122) und Reihen ungeradzahliger elektrischer Bauelemente (123) der Abstand entlang der Länge L zwischen zwei elektrischen Bauelementen (120) einer gleichen Reihe kleiner ist als der zum Einsetzen eines elektrischen Bauelements erforderliche Abstand.

3. Vorrichtung nach Anspruch 1 oder 2, wobei der Abstand in der Breite l zwischen Reihen geradzahliger elektrischer Bauelemente (122) und Reihen ungeradzahliger elektrischer Bauelemente (123), die auf der gleichen Seite angeordnet sind, regelmäßig ist, wobei dieser Abstand vorteilhafterweise kleiner ist als der zum Einsetzen eines elektrischen Bauelements erforderliche Abstand.

4. Vorrichtung nach einem der Ansprüche 1 bis 3, wobei in jeder der Reihen geradzahliger (122) und ungeradzahliger (123) elektrischer Bauelemente die Anordnung der elektrischen Bauelemente regelmäßig mit einer Teilung T in der Längsrichtung L ist.

5. Vorrichtung nach Anspruch 4, wobei die Reihen geradzahliger elektrischer Bauelemente (122) auf beiden Seiten des Trägers (100) miteinander in Phase sind und die Reihen ungeradzahliger elektrischer Bauelemente (123) auf beiden Seiten des Trägers (100) ebenfalls miteinander in Phase sind, wobei die Reihen geradzahliger elektrischer Bauelemente (122) vorteilhafterweise einen Versatz entlang der Länge L in Bezug auf die Reihen ungeradzahliger elektrischer Bauelemente (123) aufweisen, wobei der Versatz vorteilhafterweise eine halbe Teilung T/2 beträgt.

6. Vorrichtung nach einem der Ansprüche 1 bis 5, wobei der Träger (100) eine Abschirmschicht (140) umfasst, die zwischen zwei Schichten elektrischer Isolierung (104/105) angeordnet ist und parallel zu beiden Seiten des Trägers (100) angeordnet ist, wobei die Abschirmschicht (140) so ausgebildet ist, dass sie das Übersprechen zwischen elektrischen Bauelementen (120), die einander über die Dicke E des Trägers (100) gegenüberliegen, reduziert.

7. Vorrichtung nach einem der Ansprüche 1 bis 6, wobei die zweiten Stufen (112) entlang der Länge L parallel zueinander angeordnet sind, wobei die zweiten Stufen (112) auf der Vorderseite gegenüber den zweiten Stufen (112) auf der Rückseite (102) um die Breite l versetzt sind, derart, dass keine elektrischen Bauelemente der zweiten Stufen (112) auf der einen Seite auch nur teilweise einem anderen auf der anderen Seite angeordneten elektrischen Bauelement gegenüberliegen.

8. Vorrichtung nach Anspruch 7, wobei sich die Abschirmschicht (140) nur über eine erste Oberfläche (150) erstreckt, wobei die erste Oberfläche (150) die Oberfläche ist, die der von den ersten Stufen (111) eingenommenen Oberfläche gegenüber liegt.

9. Vorrichtung nach Anspruch 8, wobei zwei erste Stufen (111), die jeweils auf einer anderen Seite des Trägers (100) angeordnet sind, nur eine Reihe von elektrischen Bauelementen (120) aufweisen können, die einander über die Dicke E des Trägers (100) gegenüberliegen, so dass mindestens eine Reihe von Bauelementen auf einer der beiden Seiten keiner Reihe gegenüberliegt, die auf der anderen Seite angeordnet ist, wobei sich die Abschirmschicht (140) vorteilhafterweise nur über eine zweite Fläche (160) erstreckt, wobei die zweite Fläche (160) auf die Projektion in Richtung E der Fläche begrenzt ist, die von den Reihen der Vorderseite (101) eingenommen wird, die jeweils eine Reihe der Rückseite (102) gegenüber aufweisen.

10. Vorrichtung nach einem der Ansprüche 1 bis 9, wobei die zweiten Stufen (111) der Spannungsteiler (110) ein freies Ende zum Anschluss an eine Niederspannungsquelle aufweisen.

11. Vorrichtung nach einem der Ansprüche 1 bis 10, wobei die ersten Stufen (112) der Spannungsteiler (110) jeweils ein freies Ende aufweisen, das an eine Spannungsmessvorrichtung anzuschließen ist, wobei vorteilhafterweise ein Ethernet-Verbinder des RJ45-Typs auf dem Träger (100) angeordnet ist, um die Verbindung zwischen den freien Enden der ersten Stufen (112) und der Spannungsmessvorrichtung herzustellen.

12. Vorrichtung nach einem der Ansprüche 1 bis 11, wobei die elektrischen Bauelemente der Spannungsteiler (110) zusammen mit dem Träger (100) eine gedruckte Schaltung bilden.

13. Vorrichtung nach einem der Ansprüche 1 bis 12, wobei alle elektrischen Bauelemente (120) aller Spannungsteiler (110) identisch sind, wobei die elektrischen Bauelemente vorteilhafterweise elektrische Widerstände sind.

14. Vorrichtung nach einem der Ansprüche 1 bis 13, wobei der Träger (100), der die Spannungsteiler (110) umfasst, ferner ein Formteil und eine Umspritzung umfasst, die dazu bestimmt sind, eine elektrische Isolierung und mechanische Festigkeit der Vorrichtung zu gewährleisten.

15. Vorrichtung nach Anspruch 14, wobei die Vorrichtung mit Mitteln zur Befestigung (230) an einer Schiene (250), zum Beispiel einer DIN-Schiene, versehen ist.

## Claims

1. Electrical insulation device (10) comprising:
- a support (100) of thickness E comprising two faces facing one another, referred to as, respectively, front face (101) and rear face (102), with the two faces having a length L, a width 1,
- on each face of the support (100) being disposed a plurality of voltage dividers (110) extending over the length L of said face, each voltage divider (110) comprising electrical components (120) connected in series and arranged successively along a first stage (111) and a second stage (112), each first stage (111) comprising a row of even electrical components (122) and a row of odd electrical components (123), the two rows being parallel along the length L, and adjacent along the width 1, and the second stage (112) corresponding to an arrangement in line of the electrical components (120).

2. Device according to claim 1, wherein for each one of the rows of even electrical components (122) and rows of odd electrical components (123), the spacing along the length L between two electrical components (120) of the same row is less than the spacing required for the insertion of an electrical component.

3. Device according to claim 1 or 2, wherein the spacing, along the width 1, of the rows of even electrical components (122) and of the rows of odd electrical components (123) disposed on the same face is regular, with this spacing advantageously being less than the spacing required for the insertion of an electrical component.

4. Device according to one of claims 1 to 3, wherein in each one of the rows of even (122) and odd (123) electrical components, the arrangement of said electrical components is regular along a pitch T in the direction of the length L.

5. Device according to claim 4, wherein the rows of even electrical components (122) of the two faces of the support (100) are in phase together, and the rows of odd electrical components (123) of the two faces of the support (100) are also in phase between them, advantageously, the rows of even electrical components (122) have a shift along the length L with respect to the rows of odd electrical components (123), the shift being advantageously a half pitch T/2.

6. Device according to one of claims 1 to 5, wherein the support (100) comprises a shielding layer (140) inserted between two layer of electrical insulation (104/105), and disposed parallel to the two faces of the support (100), the shielding layer (140) being suitable for reducing the crosstalk between electrical components (120) facing one another through the thickness E of the support (100).

7. Device according to one of claims 1 to 6, wherein the second stages (112) are arranged parallel to one another along the length L, the second stages (112) of the front face being shifted along the width 1 with respect to the second stages (112) of the rear face (102) in such a way that no electrical component of the second stages (112) on one face is facing, even partially, another electrical component disposed on the other face.

8. Device according to claim 7, wherein the shielding layer (140) extends only over a first face (150), the first face (150) being the face facing the face occupied by the first stages (111).

9. Device according to claim 8, wherein two first stages (111), each disposed on a different face of the support (100) can have only one row of electrical components (120) facing one another through the thickness E of the support (100), in such a way that at least one row of components on one of the two faces is not facing any row disposed on the other face, advantageously, the shielding layer (140) extends only over a second face (160), the second face (160) being limited to the projection along the direction E of the face occupied by the rows of the front face (101) each having a row of the facing rear face (102).

10. Device according to one of claims 1 to 9, wherein the second stages (111) of the voltage dividers (110) comprise a free end intended to be connected to a source of low voltage.

11. Device according to one of claims 1 to 10, wherein the first stages (112) of the voltage dividers (110) each comprise a free end intended to be connected to a device for measuring voltage, advantageously, an Ethernet connector of the RJ45 type is disposed on the support (100), in such a way as to provide the connection between the free ends of the first stages (112) and the device for measuring voltage.

12. Device according to one of claims 1 to 11, wherein the electrical components of the voltage dividers (110) form with the support (100) a printed circuit.

13. Device according to one of claims 1 to 12, wherein all the electrical components (120) of all the voltage dividers (110) are identical, advantageously the electrical components are electrical resistances.

14. Device according to one of claims 1 to 13, wherein the support (100) comprising the voltage dividers (110) further comprises a moulding and an overmoulding intended to provide an electrical insulation and a mechanical resistance of the device.

15. Device according to claim 14, wherein the device if provided with means of fastening (230) on a rail (250), for example a DIN rail.
